# FASCICULE DE BREVET EUROPEEN

(11) **EP 0 541 420 B1**
(45) Date de publication et mention de la délivrance du brevet: **02.11.1995**
(21) Numéro de dépôt: 92402899.6
(22) Date de dépôt: 26.10.1992
(51) Int. Cl.: H01S 3/10, H01S 3/096, H04B 10/04, H04B 10/12

(54) **Générateur optique, notamment pour le transport d'un signal hyperfréquence**
Optischer Generator zur Übertragung eines Mikrowellensignals
Optical generator for microwave signal transmission

(30) Priorité: 31.10.1991 FR 9113513
(43) Date de publication de la demande: 12.05.1993
(73) Titulaire: ALCATEL N.V., NL-1077 XX Amsterdam (NL)
(72) Inventeur: Brindel, Patrick, F-92700 Colombes (FR); Trotel, Annaick, F-22550 Matignon (FR)
(74) Mandataire: Bourely, Paul

(56) Documents cités:
- EP-A- 0 120 389
- DE-A- 3 508 034
- PATENT ABSTRACTS OF JAPAN vol. 7, no. 76 (E-167)30 Mars 1983 & JP-58 003 431
- PATENT ABSTRACTS OF JAPAN vol. 9, no. 212 (E-339)29 Août 1985 & JP-60 074 737
- PATENT ABSTRACTS OF JAPAN vol. 11, no. 164 (P-580)27 Mai 1987 & JP-61 296 539

## Description

La présente invention concerne un générateur optique du genre comportant un laser polarisé par un courant de polarisation continu et commandé par un courant de commande alternatif pour émettre une onde lumineuse modulée. Elle trouve, notamment mais non exclusivement, application dans le transport de signaux hyperfréquence, cette expression désignant notamment ici une onde hyperfréquence modulée par un signal utile.

Le transport de signaux hyperfréquence sur de grandes distances est difficile à réaliser actuellement à cause de l'atténuation des câbles coaxiaux et des guides métalliques. Cette atténuation est par exemple de l'ordre de 0,5 dB/m pour un câble type 17/18-RG 217 à 3 GHz. Le déport d'antenne, la distribution de signaux hyperfréquence sont des exemples d'application nécessitant le transport de signaux hyperfréquence. Les liaisons optiques offrent une alternative intéressante car une fibre optique a une atténuation de l'ordre de 0,2 dB/km et sur de grandes distances les pertes de conversion électrique optique et optique électrique de l'émetteur et du récepteur sont compensées par la très faible atténuation.

Un générateur optique est décrit dans JP-A-58 003 431.

Malheureusement si une fibre optique possède une bande passante importante, il n'en est pas de même des composants d'extrémité. En particulier les laser connus ont une bande passante limitée. La limitation de la bande passante est principalement due aux boîtiers des lasers en raison des fréquences de coupure présentées par ces boîtiers. Les puces semi-conductrices qui constituent ces lasers sont intrinsèquement capables de fonctionner à des fréquences plus élevées. L'amélioration des boîtiers est possible mais coûteuse.

La présente invention a notamment pour buts :
- de contourner cette limitation de bande passante des boîtiers,
- de réaliser de manière peu coûteuse un système de transport de signaux notamment hyperfréquence,
- de réaliser de manière peu coûteuse un système de conversion de fréquence pour un signal notamment hyperfréquence, notamment si ce signal doit être transporté par un guide optique,
- d'engendrer de manière peu coûteuse une onde lumineuse modulée à une fréquence modifiée, et notamment accrue, par rapport à la fréquence d'un signal, notamment hyperfréquence, qui doit être porté par cette onde.

Selon la présente invention, comme définie dans les revendications 1 et 9, de tels buts peuvent être atteints grâce à l'utilisation d'un laser polarisé au voisinage du coude de sa courbe caractéristique et commandé par plusieurs courants de commande.

Ce choix du courant de polarisation permet à ce laser de mélanger ces courants en combinant leurs fréquences pour moduler l'onde lumineuse qu'il émet.

A l'aide des figures schématiques, ci-jointes, on va décrire l'art antérieur et plus particulièrement, à titre d'exemple non limitatif, comment la présente invention peut être mise en oeuvre.
- Les figures 1 et 2 représentent des vues de deux systèmes connus pour le transport d'un signal hyperfréquence.
- La figure 3 représente une vue d'un système selon la présente invention pour le transport d'un signal hyperfréquence.
- La figure 4 représente une vue simplifiée de la courbe caractéristique d'un laser du système de la figure 3.

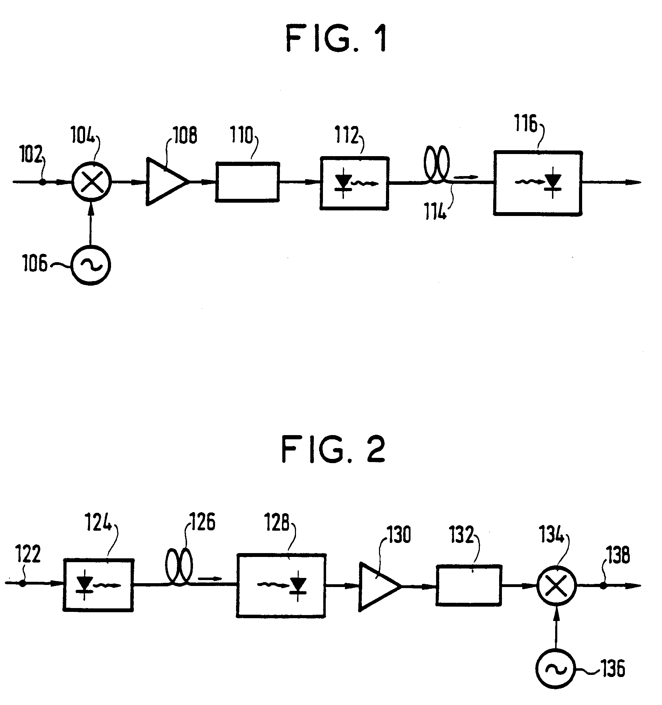

Le système connu de la figure 1 comporte une entrée 102 pour recevoir une onde de base qui est une onde hyperfréquence à une fréquence de base et qui est modulée par un signal utile. Cette onde est fournie à un mélangeur hyperfréquence 104. Ce dernier reçoit par ailleurs une onde locale fournie à une fréquence locale par un oscillateur local 106. Il fournit notamment une onde transposée dont la fréquence est une fréquence transposée égale à la somme de la fréquence de base et de la fréquence locale, cette opération constituait une transposition de fréquence.

Cette onde transposée traverse un amplificateur 108 et un filtre égaliseur 110 avant d'être appliquée à un laser 112 constitué d'une puce semi-conductrice disposée dans un boîtier non représenté. Les pertes de puissance dans le mélangeur 104 et le filtre égaliseur rendent la présence de l'amplificateur 108 nécessaire pour que cette onde puisse utilement constituer le courant de commande de ce laser. Ce dernier émet une onde lumineuse modulée qui est guidée par une fibre optique 114 qui constitue une fibre de transport et qui transmet cette onde à un photodétecteur 116 situé à distance du laser 112. Ce dernier restitue l'onde transposée sous la forme d'une onde électrique d'hyperfréquence.

Dans le cas où, par exemple, la fréquence de base, locale et transposée doivent être égales à 0,89 GHz, 1 GHz et 1,89 GHz, respectivement, la réalisation du boîtier du laser 112 serait fort coûteuse.

Les éléments du système connu de la figure 2 sont équivalents à ceux du système représenté à la figure 1. Cependant les places de ces éléments ont changé. L'entrée 122 du système représenté à la figure 2 reçoit une onde de base notamment d'hyperfréquence. Cette onde est appliquée à un laser 124 constitué d'une puce semi-conductrice disposée dans un boîtier non représenté. Ce laser émet une onde lumineuse modulée qui est guidée par une fibre optique 126 qui constitue une fibre de transport et qui transmet cette onde à un photodétecteur 128 situé à distance du laser 122. Le photodétecteur 128 restitue l'onde de base sous la forme d'une onde électrique hyperfréquence. Cette onde est alors fournie à un mélangeur hyperfréquence 134 après avoir été remise à niveau par un amplificateur hyperfréquence 130 et remise en forme par un filtre égaliseur 132. Ce mélangeur reçoit également une onde locale fournie à une frequence locale par un oscillateur local 136. Ce mélangeur 134 délivre en sortie 138 une onde électrique transposée dont la fréquence est égale à la somme de la fréquence de base et de la fréquence locale.

Dans le cas d'un déport d'antenne, ce système oblige à placer le mélangeur et l'oscillateur local près de l'antenne, le plus souvent à l'extérieur, ce qui augmente les contraintes climatiques qui influent sur la fiabilité donc sur le coût de ces composants.

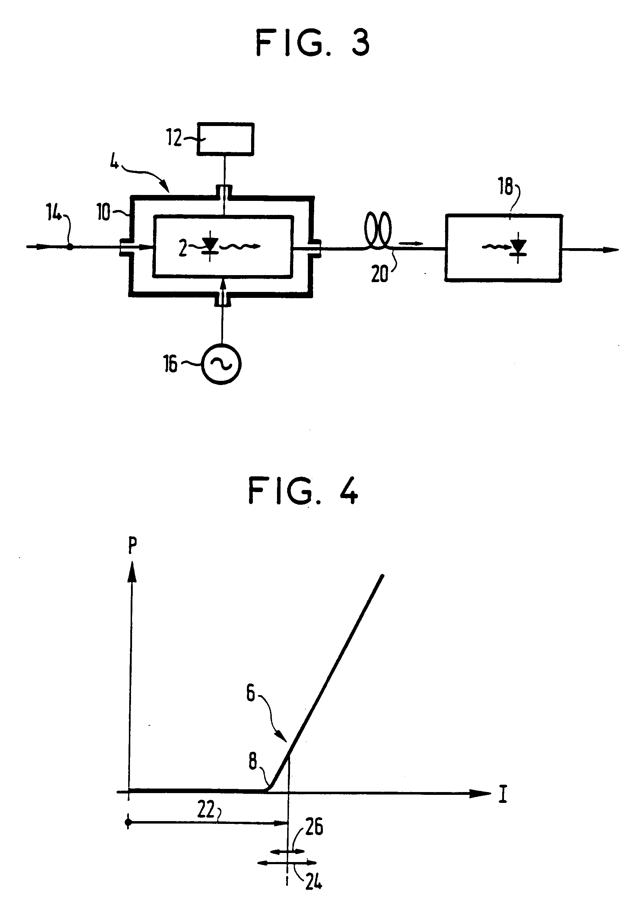

En se référant à la figure 3 on va maintenant décrire d'abord divers éléments qui sont communs, quant à leurs fonctions indiquées au système connu de la figure 1 et à un système de transport de signal constitué par un générateur mettant la présente invention en oeuvre.

Ces éléments communs sont les suivants :
- Une puce semi-conductrice 2 pour constituer un laser 4. Ce laser est polarisé par un courant de polarisation continu et commandé par un courant de commande alternatif pour émettre une onde lumineuse modulée en amplitude. Une courbe caractéristique 6 de ce laser définit l'amplitude de cette onde en fonction de la somme des courants qui lui sont appliqués. Cette courbe présente un coude 8.
- Un boîtier 10 pour contenir cette puce 2. Ce boîtier comporte des éléments de connexion électriques permettant d'appliquer ces courants de polarisation et de commande à cette puce. Il présente une fréquence de coupure au-delà de laquelle il ne permet plus d'appliquer un tel courant de commande.
- Des sources électriques de polarisation 12 et de commande pour fournir ces courants de polarisation et de commande.

Dans les systèmes connus des figures 1 et 2, la transposition de fréquence est dévolue au mélangeur 104 ou 134 et nécessite une remise en forme du signal. Elle est réalisée par les éléments 102 à 110 de la figure 1 et 130 à 138 de la figure 2.

Aux éléments communs précédemment indiqués s'ajoutent :
- Une fibre optique de transport 20 qui reçoit en sortie du laser 4 l'onde lumineuse modulée et qui guide cette onde lumineuse à distance jusqu'à un détecteur optoélectronique 18.
- Le détecteur optoélectronique 18 qui reçoit en sortie de fibre l'onde lumineuse et qui délivre en sortie de détecteur l'onde sous forme électrique. L'ensemble de la liaison optique réalise le transport d'un signal utile qui module à l'entrée l'onde de base et en sortie l'onde transposée.

Le système de la figure 3 comporte deux sources électriques de commande de 14, 16 pour fournir simultanément deux courants de commande élémentaires présentant deux fréquences élémentaires inférieures à la fréquence de coupure du boîtier 10 du laser 4, respectivement. Ce boîtier comporte des éléments de connexion pour appliquer ces deux courants de commande élémentaires à la puce semi-conductrice 2 du laser 4. La source de polarisation 12 fournit un courant de polarisation polarisant ce laser au voisinage du coude 8 de sa courbe caractéristique 6. La modulation se fait ainsi dans une zone de très forte non linéarité de la courbe caractéristique du laser. Il en résulte que le laser réalise le mélange de ces deux courants de commande élémentaires pour moduler ladite onde lumineuse par une onde transposée ayant une fréquence transposée égale à la somme des deux fréquences élémentaires ou, éventuellement, à une autre combinaison linéaire de ces deux fréquences.

Une première source électrique de commande est constituée par une entrée 14 du générateur pour recevoir une onde de base modulée par un signal utile et pour fournir au laser 4 un premier courant de commande élémentaire constitué par cette onde de base. La deuxième source électrique de commande est constituée par un oscillateur local 16 fournissant une onde locale constituant le deuxième courant de commande élémentaire et présentant une fréquence locale.

Le générateur ainsi constitué réalise le transport d'un signal utile modulait à l'entrée l'onde de base et en sortie l'onde transposée.

La présente invention s'applique avantageusement lorsque la somme des fréquences élémentaires est supérieure à la fréquence de coupure du boîtier 10 du laser 4. Cette dernière est souvent comprise entre 0,8 et 1,8 GHz et typiquement voisine de 1,2 GHz.

Les fréquences de base, locale et transposée sont par exemple respectivement égales à 0,89 GHz, 1 GHz et 1,89 GHz. La fréquence de coupure du boîtier 10 peut alors être peu supérieure à 1 GHz, ce qui permet d'utiliser un boîtier de type classique et peu coûteux. La puce semi-conductrice 2 peut elle aussi être d'un type connu et peu coûteux. Ceci tient au fait que, typiquement, pour un laser à faible coût, la fréquence de coupure de la puce semi-conductrice peut être cinq fois celle du boîtier.

La présente invention permet en outre de supprimer le mélangeur hyperfréquence, ce qui diminue encore plus le coût de la liaison.

Sur la figure 4 on a porté en abscisse l'intensité globale I des deux courants de commande et en ordonnées la puissance lumineuse P de l'onde modulée émise par le laser 4. Des flèches 22, 24 et 26 représentent l'intensité du courant de polarisation et l'amplitude des variations que les ondes de base et locale superposent à ce courant, respectivement.

Le laser 4 peut être par exemple un laser de la société française CIT ALCATEL du type DL 2500/1300 dont la courbe caractéristique présente un coude à 31 mA. On peut lui appliquer un courant de polarisation de 34 mA. Les ondes de base et locale peuvent alors avoir des puissances de -16 et -14 dBm, respectivement, et permettre d'émettre une onde lumineuse modulée à la fréquence transposée avec une puissance de -50 dBm mesurés au niveau de la photodiode avant une éventuelle amplification.

Dans certains cas la fréquence transposée Ft peut être égale à la somme de la fréquence de base Fb et d'une harmonique de la fréquence locale Lo. On peut avoir par exemple Ft = Fb + 2 Lo.

## Revendications

1. Générateur optique, notamment pour le transport d'un signal hyperfréquence, ce générateur comportant :
- un laser (4) pour émettre une onde lumineuse modulée en amplitude,
- une source de polarisation (12) apte à fournir à ce laser un courant de polarisation continu,
- et une première source de commande (14) apte à fournir à ce laser un premier courant de commande alternatif,
ce générateur étant caractérisé par le fait que ladite source de polarisation est agencée pour polariser ledit laser au voisinage du coude de sa courbe caractéristique définissant l'amplitude d'une onde lumineuse émise par ce laser, en fonction de la somme des courants qui sont appliqués à ce laser,
ce générateur comportant en outre une deuxième source de commande apte à fournir à ce laser un deuxième courant de commande alternatif simultané avec ledit courant de polarisation et le premier dit courant de commande.

2. Générateur selon la revendication 1, dans lequel une puce semi-conductrice (2) constitue ledit laser (4), ce laser étant commandé par lesdits courants de commande pour moduler ladite onde lumineuse en amplitude, un boîtier (10) contenant cette puce (2) et comportant des éléments de connexion électriques permettant d'appliquer lesdits courants de polarisation et de commande à cette puce, ce boîtier présentant une fréquence de coupure au-delà de laquelle il ne permet plus d'appliquer un tel courant de commande,
ce générateur étant caractérisé par le fait que lesdits premier et deuxième courants de commande présentent respectivement deux fréquences élémentaires inférieures à la fréquence de coupure du boîtier (10).

3. Générateur selon la revendication 2, caractérisé par le fait qu'une première dite source électrique de commande est constituée par une entrée (14) de ce générateur pour recevoir une onde de base modulée par un signal utile et pour fournir audit laser (4) un premier dit courant de commande constitué par cette onde de base,
- la deuxième dite source électrique de commande étant constituée par un oscillateur local (16) fournissant une onde locale constituant le deuxième dit courant de commande.

4. Générateur selon la revendication 3, ce générateur comportant en outre un détecteur optoélectronique (18) pour recevoir ladite onde lumineuse modulée en sortie du laser (4) et pour fournir en réponse une onde électrique, grâce à quoi ce générateur réalise une conversion de fréquence.

5. Générateur selon la revendication 4, ledit détecteur optoélectronique (18) étant situé à distance du laser (4), ce générateur comportant en outre une fibre optique de transport (20) pour recevoir ladite onde lumineuse modulée en sortie de ce laser, et pour guider cette onde jusqu'à ce détecteur optoélectronique, grâce à quoi ce générateur constitue une liaison optique réalisant en outre un transport du signal utile modulant ladite onde de base.

6. Générateur selon l'une quelconque des revendications 3 à 5, dans lequel lesdites ondes de base et locale sont des ondes d'hyperfréquences.

7. Procédé pour faire émettre par un laser une onde lumineuse modulée en amplitude à une fréquence supérieure à celle d'un premier courant de commande alternatif appliqué à ce laser, ce procédé étant caractérisé par le fait qu'on polarise ce laser par un courant continu au voisinage du coude de sa courbe caractéristique définissant l'amplitude d'une onde émise par ce laser en fonction de la somme des courants qui sont appliqués à ce laser, ce qui donne à ce laser des propriétés non linéaires, et on applique en outre à ce laser un deuxième courant de commande alternatif simultanément avec ledit premier courant de commande et avec ledit courant continu, grâce à quoi ce laser réalise un mélange de ces deux courants de commande pour moduler l'onde lumineuse émise par ce laser par une onde transposée ayant une fréquence transposée égale à une combinaison linéaire des fréquences des deux courants de commande.

8. Procédé selon la revendication 7, dans lequel le premier dit courant de commande est constitué par une onde de base modulée par un signal utile qui est à transmettre par l'intermédiaire de ladite onde lumineuse.

9. Procédé selon la revendication 7, caractérisé par le fait que ladite fréquence transposée est égale à la somme des fréquences des deux dits courants de commande.

10. Procédé selon la revendication 9 caractérisé par le fait que ladite fréquence transposée est comprise entre une fréquence de coupure d'un boîtier (4) dudit laser (10) et le double de cette fréquence de coupure, cette fréquence de coupure étant supérieure à 0,8 GHz.

## Patentansprüche

1. Optischer Generator, insbesondere für den Transport eines Mikrowellensignals, wobei der Generator enthält:
- einen Laser (4), der eine amplitudenmodulierte Lichtwelle aussenden kann,
- eine Polarisationsquelle (12), die diesem Laser einen Gleichstrom zuführen kann,
- und eine erste Steuerquelle (14), die diesem Laser einen ersten Steuerwechselstrom zuführen kann,
dadurch gekennzeichnet, daß die Polarisationsquelle so gewählt ist, daß der Laser in der Nähe des Knickpunkts seiner Kennlinie betrieben wird, die die Amplitude einer von diesem Laser ausgesendeten Lichtwelle abhängig von der Summe der an diesen Laser angelegten Ströme definiert, und daß der Generator weiter eine zweite Steuerquelle aufweist, die an den Laser einen zweiten Steuerwechselstrom gleichzeitig mit dem Polarisationsstrom und dem ersten Steuerwechselstrom liefern kann.

2. Generator nach Anspruch 1, bei dem ein Halbleiterchip (2) den Laser (4) bildet und der Laser von den Steuerströmen gesteuert wird, um die Amplitude der Lichtwelle zu modulieren, wobei ein Gehäuse (10) den Halbleiterchip (2) und elektrische Anschlußelemente enthält, mit denen der Polarisationsstrom und die Steuerströme an den Halbleiter angelegt werden können, wobei das Gehäuse eine Grenzfrequenz besitzt, oberhalb der ein solcher Steuerstrom nicht mehr angelegt werden kann,
dadurch gekennzeichnet, daß der erste bzw. zweite Steuerwechselstrom zwei Elementarfrequenzen bilden, die unter der Grenzfrequenz des Gehäuses (10) liegen.

3. Generator nach Anspruch 2, dadurch gekennzeichnet, daß eine erste elektrische Steuerquelle von einem Eingang (14) dieses Generators gebildet wird, um eine mit einem Nutzsignal modulierte Basiswelle zu empfangen und um an den Laser (4) einen ersten Steuerstrom zu liefern, der von dieser Basiswelle geliefert wird, und daß die zweite elektrische Steuerstromquelle von einem örtlichen Oszillator (16) gebildet wird, der eine den zweiten Steuerstrom bildende örtliche Welle liefert.

4. Generator nach Anspruch 3, dadurch gekennzeichnet, daß er weiter einen opto-elektronischen Detektor (18) enthält, der die modulierte Lichtwelle am Ausgangs des Lasers (4) empfängt und daraus eine elektrische Welle erzeugt, so daß der Generator eine Frequenzumwandlung durchführt.

5. Generator nach Anspruch 4, bei dem der opto-elektronische Detektor (18) in einer Entfernung vom Laser (4) angeordnet ist, wobei der Generator außerdem eine Lichtleitfaser (20) enthält, die die modulierte Lichtwelle vom Ausgang dieses Lasers empfängt und bis zum opto-elektronischen Detektor führt, so daß der Generator eine optische Verbindung darstellt, die außerdem einen Transport des die Basiswelle modulierenden Nutzsignals realisiert.

6. Generator nach einem beliebigen der Ansprüche 3 bis 5, bei dem die Basiswelle und die örtliche Welle Mikrowellen sind.

7. Verfahren zum Aussenden einer amplitudenmodulierten Lichtwelle durch einen Laser, wobei die Lichtwelle eine höhere Frequenz als die eines ersten an diesen Laser angelegten Steuerwechselstroms besitzt, dadurch gekennzeichnet, daß der Laser durch einen Gleichstrom in der Nähe des Knickpunkts seiner Kennlinie betrieben wird, die die Amplitude einer von diesem Laser ausgesendeten Welle abhängig von der Summe der Ströme definiert, die an den Laser angelegt werden, so daß der Laser nicht-lineare Eigenschaften bekommt, und daß weiter an diesen Laser ein zweiter Steuerwechselstrom gleichzeitig mit dem ersten Steuerwechselstrom und dem Gleichstrom angelegt wird, so daß der Laser eine Mischung dieser beiden Steuerströme erzeugt, um die von diesem Laser ausgesendete Lichtwelle mit einer umgesetzten Welle zu modulieren, die eine umgesetzte Frequenz gleich einer linearen Kombination der Frequenzen der beiden Steuerströme bildet.

8. Verfahren nach Anspruch 7, bei dem der erste Steuerstrom von einer Basiswelle gebildet wird, die von einem Nutzsignal moduliert ist, das über die Lichtwelle übertragen werden soll.

9. Verfahren nach Anspruch 7, dadurch gekennzeichnet, daß die umgesetzte Frequenz gleich der Summe der Frequenzen der beiden Steuerströme ist.

10. Verfahren nach Anspruch 9, dadurch gekennzeichnet, daß die umgesetzte Frequenz zwischen einer Grenzfrequenz eines Gehäuses (4) dieses Lasers (10) und dem Doppelten dieser Grenzfrequenz liegt, wobei die Grenzfrequenz oberhalb von 0,8 GHz liegt.

## Claims

1. A light generator, in particular for conveying a microwave signal, the generator including:
a laser (4) to emit an amplitude modulated lightwave;
a bias source (12) suitable for delivering a DC bias current to said laser; and
a first control source (14) suitable for delivering a first AC control current to said laser;
said generator being characterized by the fact that said bias source is set to bias said laser close to the bend in its characteristic curve defining the amplitude of a lightwave emitted by said laser, as a function of the sum of the currents applied to said laser;
said generator further including a second control source suitable for delivering a second AC control current to said laser, simultaneously with said bias current and the first one of said control currents.

2. A generator according to claim 1, in which a semiconductor chip (2) constitutes said laser (4), said laser being being controlled by said control currents to modulate said lightwave in amplitude; said chip (2) being contained in a package (10) also including electrical connection elements enabling said bias and control currents to be applied to said chip, said package having a cutoff frequency beyond which it does not allow such a control current to be applied;
said generator being characterized by the fact that said first and second control currents have respective individual frequencies, both of which are lower than the cutoff frequency of the package (10).

3. A generator according to claim 2, characterized by the fact that a first one of said control electricity sources is constituted by an input (14) of said-generator for receiving a base wave that is modulated by a useful signal and for providing said laser (4) with a first one of said control currents as constituted by said base wave;
said second control electricity source being constituted by a local oscillator (16) providing a local wave constituting the said second control current.

4. A generator according to claim 3, said generator further including an optoelectronic detector (18) for receiving said modulated lightwave output from the laser (4) and for responding by providing an electrical wave, whereby said generator performs frequency conversion.

5. A generator according to claim 4, said optoelectronic generator (18) being situated remotely from the laser (4), said generator further including a transport optical fiber (20) for receiving said modulated lightwave output from said laser and for guiding said wave to said optoelectronic detector, whereby said generator constitutes an optical link further serving to transport the useful signal that modulates said base wave.

6. A generator according to any one of claims 3 to 5, in which said base wave and said local wave are both microwaves.

7. A method of emitting by laser an amplitude modulated lightwave at a frequency greater than that of a first AC control current applied to said laser, said method being characterized by the fact that said laser is biased by a DC current to be close to the bend in its characteristic curve defining the amplitude of the wave emitted by said laser as a function of the sum of the currents applied to said laser, thereby giving said laser non-linear properties, and a second AC control current is also applied to said laser simultaneously with said first control current and with said DC current, whereby said laser mixes said two control currents to modulate the lightwave emitted by said laser with a transposed wave having a transposed frequency equal to a linear combination of the frequencies of the two control currents.

8. A method according to claim 7, in which the first one of said control currents is constituted by said base wave modulated by a useful signal which is transmitted by means of said lightwave.

9. A method according to claim 7, characterized by the fact that said transposed frequency is equal to the sum of the frequencies of said two control currents.

10. A method according to claim 9, characterized by the fact that said transposed frequency lies between a cutoff frequency of a package (4) of said laser (10) and twice said cutoff frequency, said cutoff frequency being greater than 0·8 GHz.
